# EUROPÄISCHE PATENTSCHRIFT

(11) **EP 1 334 060 B1**
(45) Veröffentlichungstag und Bekanntmachung des Hinweises auf die Patenterteilung: **22.03.2006**
(21) Anmeldenummer: 01992685.6
(22) Anmeldetag: 06.10.2001
(51) Int. Cl.: B81B 3/00

(54) **MIKROMECHANISCHES BAUELEMENT UND ENTSPRECHENDES HERSTELLUNGSVERFAHREN**
MICROMECHANICAL COMPONENT AND CORRESPONDING PRODUCTION METHOD
COMPOSANT MICROMECANIQUE ET PROCEDE DE PRODUCTION CORRESPONDANT

(30) Priorität: 03.11.2000 DE 10054484
(43) Veröffentlichungstag der Anmeldung: 13.08.2003
(73) Patentinhaber: ROBERT BOSCH GMBH, 70422 Stuttgart (DE)
(72) Erfinder: BENZEL, Hubert, 72124 Pliezhausen (DE); WEBER, Heribert, 72622 Nuertingen (DE); ARTMANN, Hans, 71106 Magstadt (DE); SCHAEFER, Frank, 72070 Tuebingen (DE)
(86) Internationale Anmeldenummer: PCT/DE2001/003839
(87) Internationale Veröffentlichungsnummer: WO 2002/036484

(56) Entgegenhaltungen:
- EP-A- 0 747 684
- EP-A- 1 011 130
- WO-A-97/49475
- WO-A-99/45583
- US-A- 5 405 786

## Beschreibung

### STAND DER TECHNIK

Die vorliegende Erfindung betrifft ein mikromechanisches Bauelement mit einem Substrat aus einem Substratmaterial mit einer ersten Dotierung, einer in dem Substrat vorgesehenen mikromechanischen Funktionsstruktur und einer Abdeckschicht zum zumindest teilweisen Abdecken der mikromechanischen Funktionsstruktur. Die vorliegende Erfindung betrifft ebenfalls ein entsprechendes Herstellungsverfahren.

Unter mikromechanische Funktion soll eine beliebige aktive Funktion, z.B. eine Sensorfunktion, oder passive Funktion, z.B. eine Leiterbahnfunktion, verstanden werden.

Obwohl auf beliebige mikromechanische Bauelemente und Strukturen, insbesondere Sensoren und Aktuatoren, anwendbar, werden die vorliegende Erfindung sowie die ihr zugrundeliegende Problematik in bezug auf ein in der Technologie der Silizium-Oberflächenmikromechanik herstellbares mikromechanisches Bauelement, z.B. einen Beschleunigungssensor, erläutert.

Allgemein bekannt sind monolithisch integrierte inertiale Sensoren in Oberflächenmikromechanik (OMM), bei denen die empfindlichen beweglichen Strukturen ungeschützt auf dem Chip aufgebracht sind (Analog Devices). Dadurch entsteht ein erhöhter Aufwand beim Handling und bei der Verpackung.

Umgehen kann man dieses Problem durch einen Sensor mit der Auswerteschaltung auf einem separaten Chip, z.B. werden dabei die OMM-Strukturen mittels einem zweiten Kappenwafer abgedeckt. Diese Art der Verpackung verursacht einen hohen Anteil der Kosten eines OMM-Beschleunigungssensors. Diese Kosten entstehen durch den hohen Flächenbedarf der Dichtfläche zwischen Kappenwafer und Sensorwafer und aufgrund der aufwendigen Strukturierung (2-3 Masken, Bulkmikromechanik) des Kappenwafers.

In der DE 195 37 814 A1 werden der Aufbau eines funktionalen Schichtsystems und ein Verfahren zur hermetischen Verkappung von Sensoren in Oberflächenmikromechanik beschrieben. Hierbei wird die Herstellung der Sensorstruktur mit bekannten technologischen Verfahren erläutert. Die besagte hermetische Verkappung erfolgt mit einem separaten Kappen-Wafer aus Silizium, der mit aufwendigen Strukturierungsprozessen, wie beispielsweise KOH-Ätzen, strukturiert wird. Der Kappen-Wafer wird mit einem Glas-Lot (Seal-Glas) auf dem Substrat mit dem Sensor (Sensor-Wafer) aufgebracht. Hierfür ist um jeden Sensorchip ein breiter Bond-Rahmen notwendig, um eine ausreichende Haftung und Dichtheit der Kappe zu gewährleisten. Dies begrenzt die Anzahl der Sensor-Chips pro Sensor-Wafer erheblich. Auf Grund des grossen Platzbedarfs und der aufwendigen Herstellung des KappenWafers entfallen erhebliche Kosten auf die Sensor-Verkappung.

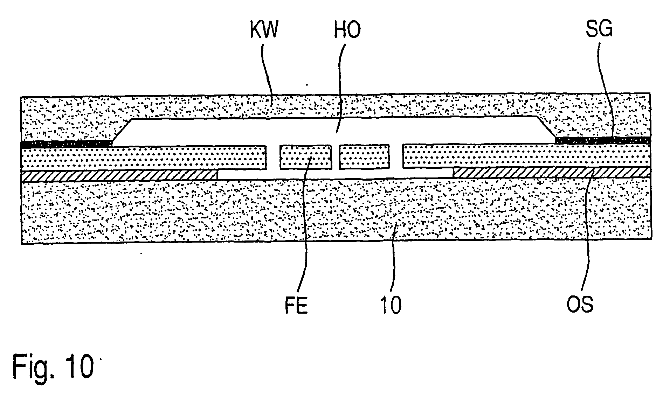

Fig. 10 zeigt eine schematische Querschnittsansicht eines bekannten mikromechanischen Bauelements.

In Figur 10 bezeichnet 10 ein Halbleitersubstrat, OS eine Opferschicht, FE eine Funktionsebene mit einer mikromechanischen Funktionsstruktur (z.B. einem Beschleunigungssensor), SG ein Sealglas, HO ein Hohlraum und KW ein Kappenwafer. Wie bereits erwähnt ist der entsprechende Herstellungsprozess relativ aufwendig, da er zwei Wafer, nämlich ein Substratwafer 10 und einen Kappenwafer KW, benötigt, welche exakt aufeinander justiert werden müssen.

Aus G. Lammel, P. Renaud, "Free-standing mobile 3D microstructures of porous silicon", Proceedings of the 13^{TH} European Conference on Solid-State Transducers, Eurosensors XIII, Den Haag, 1999, Seiten 535-536 ist es bekannt, unter einer porösen Siliziumschicht einen Hohlraum zu erzeugen.

In der europäischen Patentanmeldung EP 0 747 684 A1 ist ein Verfahren zum Formen einer Siliziumstruktur in einem Hohlraum durch Anodisieren, Oxidieren und Ätzen oder durch direktes Ätzen von porösem Silizium beschrieben. Dabei wird eine p-dotierte Schicht in ein Substrat eingebracht und eine n-dotierte Schicht auf dem n-dotierten Substrat epitaktisch abgeschieden. Anschließend werden zwei Kontaktbereiche eingebracht, welche durch die epitaktisch abgeschiedene Schicht hindurch die p-dotierte Schicht kontaktieren. Danach wird das Substrat anodisiert um poröses Silizium aus den Kontaktbereichen und der p-dotierten Schicht zu bilden. Das poröse Silizium wird oxidiert und das Oxid wird geätzt um einen Hohlraum und eine Siliziumstruktur zu formen. Alternativ wird auch das direkte Ätzen des porösen Siliziums vorgeschlagen.

### VORTEILE DER ERFINDUNG

Das erfindungsgemässe mikromechanische Bauelement mit den Merkmalen des Anspruchs 1 bzw. das Herstellungsverfahren nach Anspruch 15 ermöglichen eine einfache und kostengünstige Herstellung eines mikromechanischen Bauelements, z.B. eines Beschleunigungssensors, einer Mikropumpe, eines Strömungskanals, eines Rückschlagventils, einer Durchflussnormalen etc. unter Verwendung von porösem Substratmaterial.

Durch die Verwendung von solchem porösem Substratmaterial, insbesondere porösem Silizium, kann relativ einfach in einem Prozessschritt ein Hohlraum mit einer darüber liegenden Membran hergestellt werden. Im selben Prozessschritt können die mikromechanischen Strukturen hergestellt werden. Wesentliche Vorteile des erfindungsgemässen mikromechanischen Bauelements und des entsprechenden Herstellungsverfahrens sind also:
- die Herstellung von mikromechanischen Strukturen in einem
- Hohlraum mit darüber liegender Membran in einem einzigen Prozessschritt,
- kein Kappenwafer mit Wafer-zu-Wafer-Justage ist nötig,
- der Einschluss eines Vakuums im Hohlraum ist möglich,
- die Herstellung von Strukturen mit komplexen Tiefenprofilen ist möglich.

Die der vorliegenden Erfindung zugrundeliegende Idee besteht darin, dass die mikromechanische Funktionsstruktur Bereiche aus dem Substratmaterial mit einer zweiten Dotierung aufweist, die zumindest teilweise von einem Hohlraum umgeben sind, und die Abdeckschicht eine poröse Schicht aus dem Substratmaterial aufweist. Bei der Herstellung wird ausgenutzt, dass beim Anodisieren des Substrats die p-dotierten Bereiche gut ätzbar, jedoch die n-dotierten Bereiche nicht oder nur unwesentlich an der Oberfläche ätzbar sind.

In den Unteransprüchen finden sich vorteilhafte Weiterbildungen und Verbesserungen des jeweiligen Gegenstandes der Erfindung.

Gemäss einer bevorzugten Weiterbildung ist eine Verschlussschicht zum Verschließen der Poren der porösen Schicht erstellt, die im Hohlraum eine vorbestimmte Atmosphäre einschließt. So lässt sich unter der Membran eine vorbestimmte Atmosphäre einstellen.

Gemäss einer weiteren bevorzugten Weiterbildung weist die Verschlussschicht eine auf der porösen Schicht gebildete Oxidschicht auf.

Gemäss einer weiteren bevorzugten Weiterbildung ist über mindestens einem der Bereiche aus dem Substratmaterial mit dem zweiten Dotierungstyp ein Stützbereich zum Stützen des porösen Bereichs erstellt.

Gemäss einer weiteren bevorzugten Weiterbildung ist mindestens einer der Bereiche aus dem Substratmaterial mit dem zweiten Dotierungstyp vollständig von seiner Umgebung losgelöst.

Gemäss einer weiteren bevorzugten Weiterbildung umfasst der Hohlraum einen Strömungskanal, der durch mindestens zwei Rückseitenöffnungen anschließbar ist.

Gemäss einer weiteren bevorzugten Weiterbildung sind die Rückseitenöffnungen über eine jeweilige Durchlassöffnung angeschlossen, die im Bereich gebildet ist.

Gemäss einer weiteren bevorzugten Weiterbildung ist eine Verschlussschicht zum Verschließen der Poren der porösen Schicht vorgesehen und ist auf der Verschlussschicht eine Erfassungseinrichtung zum piezoresistiven Erfassen der Strömungsgeschwindigkeit erstellt.

Gemäss einer weiteren bevorzugten Weiterbildung ist innerhalb des Strömungskanals eine Rückschlagventileinrichtung oberhalb einer entsprechenden Durchlassöffnung erstellt, die mindestens einen der Bereiche aus dem Substratmaterial mit dem zweiten Dotierungstyp aufweist, der vollständig von seiner Umgebung losgelöst oder federnd mit dem Substratmaterial verbunden ist.

Gemäss einer weiteren bevorzugten Weiterbildung sind zwei Rückschlagventileinrichtungen unterschiedlicher Geometrie oberhalb einer entsprechenden Durchlassöffnung erstellt; der porösen Schicht vorgesehen ist und der poröse Bereich mit der Verschlussschicht als Pumpenmembran derart auslenkbar ist, dass sich das Volumen des Hohlraums verändert.

Gemäss einer weiteren bevorzugten Weiterbildung umfasst der Hohlraum einen kreisförmigen inneren Strömungskanal und einen konzentrischen äußeren Strömungskanal, welche durch radiale Durchgangsöffnungen in einem Trennbereich aus aus dem Substratmaterial mit dem zweiten Dotierungstyp verbunden sind, wobei der innere Strömungskanal durch einen Steg unterbrochen ist und auf der einen Seite des Stegs eine Rückseiten-Eingangsöffnung und auf der anderen Seite des Stegs eine erste Rückseiten-Ausgangsöffnung erstellt sind, und wobei im äußeren Strömungskanal eine zweite Rückseiten-Ausgangsöffnung erstellt ist; so dass eine durch die Rückseiten-Eingangsöffnung einströmendes Medium durch die Zentrifugalkraft massenspezifisch durch die erste und zweite Rückseiten-Ausgangsöffnung separierbar ist.

Gemäss einer weiteren bevorzugten Weiterbildung ist das Substratmaterial Silizium.

Gemäss einer weiteren bevorzugten Weiterbildung sind die Bereiche aus dem Substratmaterial mit dem zweiten Dotierungstyp in verschiedenen Tiefen im Substrat erstellt.

### ZEICHNUNGEN

Ausführungsbeispiele der Erfindung sind in den Zeichnungen dargestellt und in der nachfolgenden Beschreibung näher erläutert.

Es zeigen:
- Fig. 1a-c: eine schematische Querschnittsansicht zur Illustration einer Ausführungsform des erfindungsgemässen Herstellungsverfahrens zum Herstellen eines mikromechanischen Bauelements;
- Fig. 2: eine Variante der Ausführungsform des erfindungsgemässen Herstellungsverfahrens nach Fig. 1a;
- Fig. 3a,b: eine weitere Variante der Ausführungsform des erfindungsgemässen Herstellungsverfahrens nach Fig. 1;
- Fig. 4a-d: noch eine weitere Variante der Ausführungsform des erfindungsgemässen Herstellungsverfahrens nach Fig. 1;
- Fig. 5a,b: eine schematische Darstellung eines mikromechanischen Bauelements gemäss einer ersten Ausführungsform der vorliegenden Erfindung, und zwar Fig. 5a in Querschnittsansicht und Fig. 5b in Draufsicht;
- Fig. 6a,b: eine schematische Darstellung eines mikromechanischen Bauelements gemäss einer zweiten Ausführungsform der vorliegenden Erfindung, und zwar Fig. 6a in Querschnittsansicht und Fig. 6b in Draufsicht;
- Fig. 7a,b: eine schematische Querschnittsansicht eines mikromechanischen Bauelements gemäss einer dritten Ausführungsform der vorliegenden Erfindung, und zwar Fig. 7a mit einer Mikro-Verschlusskugel und Fig. 7b mit einer Mikro-Verschlussplatte;
- Fig. 8a,b: eine schematische Darstellung eines mikromechanischen Bauelements gemäss einer vierten Ausführungsform der vorliegenden Erfindung, und zwar Fig. 9a in Querschnittsansicht und Fig. 8b in Draufsicht;
- Fig. 9a,b: eine schematische Darstellung eines mikromechanischen Bauelements gemäss einer ersten Ausführungsform der vorliegenden Erfindung, und zwar Fig. 9a in Querschnittsansicht und Fig. 9b in Draufsicht; und
- Fig. 10: eine schematische Querschnittsansicht eines bekannten mikromechanischen Bauelements.

### BESCHREIBUNG DER AUSFÜHRUNGSBEISPIELE

In den Figuren bezeichnen gleiche Bezugszeichen gleiche oder funktionsgleiche Komponenten.

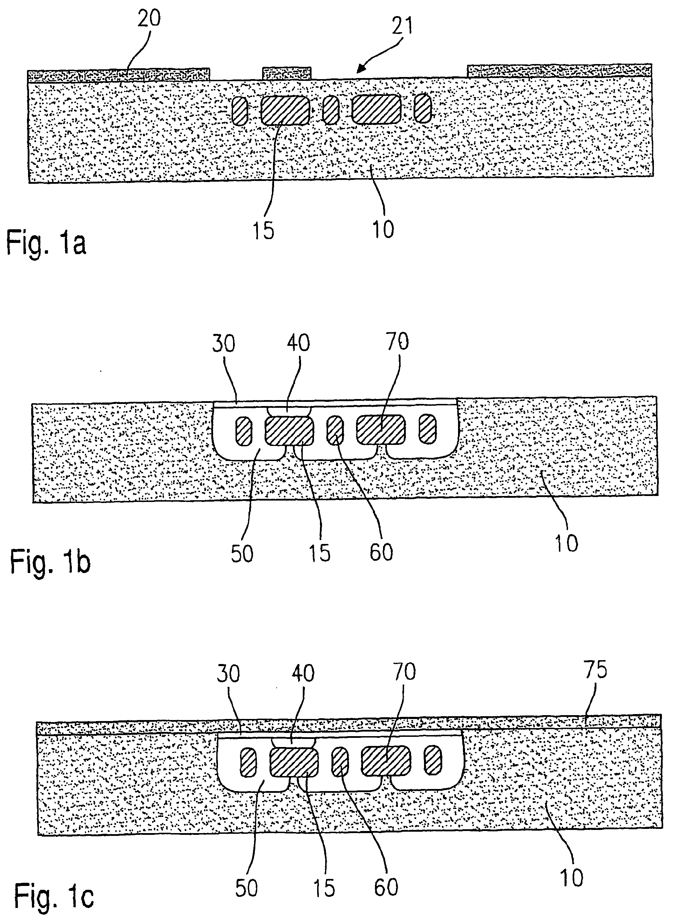

Fig. 1a-c zeigen schematische Querschnittsansichten zur Illustration einer Ausführungsform des erfindungsgemässen Herstellungsverfahrens zum Herstellen eines mikromechanischen Bauelements.

In Figur 1a bezeichnen 10 ein p-dotiertes Wafersubstrat aus Silizium, 15 n-dotierte Bereiche im Substrat 10, 20 eine Metallmaske und 21 Metallmaskenöffnungen.

Bei dem Verfahren gemäss der vorliegenden Ausführungsform werden die n-dotierten Bereiche im Substrat 10 mit Standardhalbleiterprozessen im p-dotierten Substrat 10 erzeugt. Beispiele für solche Prozesse sind Implantationsverfahren, bei denen durch die Einstellung der Energie die Eindringtiefe mit einer entsprechenden Verteilung festgelegt werden kann. Die n-dotierten Bereiche 15 sind somit in einer gewissen Tiefe unterhalb der Substratoberfläche und möglicherweise, obwohl nicht gezeigt, auch an der Substratoberfläche angeordnet.

Im darauffolgenden Prozessschritt werden Teile der Substratoberfläche mit der Metallmaske 20 maskiert. An Stelle der Metallmaske 20 könnte auch eine Nitridmaske, eine Oxinitridmaske u.ä. verwendet werden.

Mit Bezug auf Figur 1b werden die durch die Maske 20 definierten Bereiche des Substrats 10 durch Flusssäure (HF) elektrochemisch porös geätzt. Die Porosität wird dabei durch die Stromdichte gesteuert. Anfänglich wird eine geringe Stromdichte angelegt, wodurch eine Schicht mit kleiner Porosität erzeugt wird. Anschliessend wird die Stromdichte über einen kritischen Wert erhöht. Zusätzlich kann die Flusssäurekonzentration verringert werden oder andere Lösungen, die eine H₂-Bildung unterbinden, verwendet werden. Damit werden die Poren im unteren Bereich der porösen Schicht 30 derart gross, dass das Substratmaterial vollständig herausgeätzt wird und sich der Hohlraum 50 unterhalb einer verbleibenden porösen Schicht 30 bildet. In diesem Fall spricht man von Elektropolitur. Der Materialabtrag erfolgt dabei durch die poröse Schicht 30.

Die sich so bildende Struktur in der Funktionsebene, gebildet durch die Bereich 15, umfasst freigestellte Strukturen 60 und feststehende Strukturen 70, und insbesondere auch Strukturelemente, welche durch einen Stützbereich 40 mit der porösen Schicht 30 verbunden sind, also gleichsam eine Membranstütze bilden. Je nach Breite der n-dotierten Strukturen können die Strukturen also insbesondere auch unterätzt und somit freigestellt werden (siehe Bezugszeichen 60 in Figur 1b).

Bei dem erfindungsgemässen Herstellungsverfahren gemäss dieser Ausführungsform wird ausgenützt, dass unterschiedliche Dotierungen, hier n und p, im Halbleitersubstrat 10 unterschiedlich auf den elektrochemischen Ätzangriff reagieren. Insbesondere können die p-dotierten Bereiche im Halbleitersubstrat 10 sehr gut anodisiert werden, die n-dotierten Bereiche 15 wiederstehen dagegen dem Ätzangriff sehr gut. Die vergrabenen n-dotierten Bereiche 15 werden demnach während der Anodisierung nicht angegriffen. Ein eventuell oberflächig gebildeter poröser Film auf den n-dotierten Gebieten 15 kann durch Tempern in H₂ oder durch einen kurzen Dip in Silizium ätzenden Lösungen, z.B. TMAH, oder KOH-haltigen Lösungen beseitigt werden. Die Ätzfront läuft in diesem Fall um die n-dotierten Bereiche 15 herum.

Mit Bezug auf Figur 1c können die Poren des porösen Siliziumbereichs 30, die den Hohlraum 50 nach oben begrenzen, durch unterschiedliche Prozesse verschlossen werden. Möglich ist eine Schichtabscheidung mit Oxid, Nitrid, Metall, Epitaxie oder die Aufoxidation der porösen Schicht 30 zur Bildung der Verschlussschicht 75. Auch ein Tempern in H₂ kann zu einem vakuumdichten Verschluss führen, beispielsweise von Temperaturen oberhalb 1000°C. Die Druckverhältnisse während des Verschliessprozesses bestimmen den sich in Hohlraum 50 einstellenden Innendruck, wobei H₂ durch Tempern ausdiffundieren kann.

Die in Figur 1c gezeigte Struktur könnte als Beschleunigungssensor dienen. In bekannter Weise können die freigestellten Strukturen 60 bei Querbeschleunigungen schwingen, wodurch sich periodisch der Abstand zwischen den freigestellten Strukturen 60 und den feststehenden Strukturen 70 ändert. Die Abstandsänderung kann in bekannter Weise durch einen Interdigitalkondensator kapazitiv ausgewertet werden. Soll ein Vakuum unter der Verschlussmembran bestehend aus dem porösem Bereich 30 und der Verschlussschicht 75 eingeschlossen werden, so kann diese durch die besagten Schtützbereiche 40 stabilisiert werden.

Als Option können alle mit diesem Verfahren hergestellten mikromechanischen Strukturen zusammen mit einer entsprechenden integrierten Schaltung, z.B. eine Auswerteschaltung, hergestellt werden. Dazu kann optional auf den porösen Bereich eine Epitaxieschicht abgeschieden werden. Die entsprechenden Schaltungsbestandteile werden beispielsweise in CMOS, Bipolar- oder Mischprozessen hergestellt.

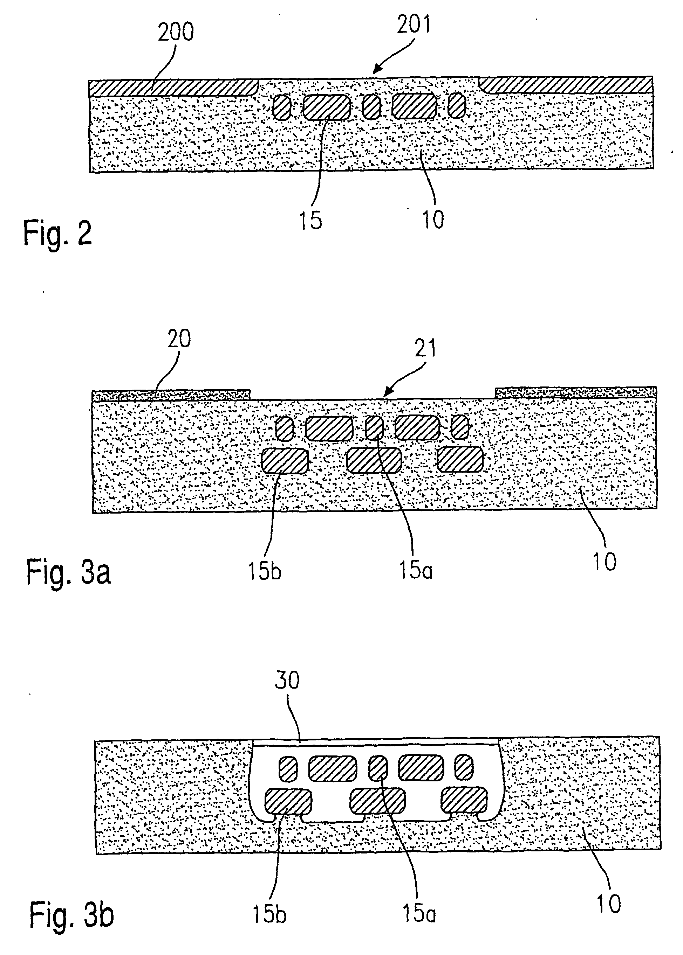

Fig. 2 zeigt eine Variante der Ausführungsform des erfindungsgemässen Herstellungsverfahrens nach Fig. 1.

Mit Bezug auf Figur 2 bezeichnet Bezugszeichen 200 eine Dotierungsmaske und 201 eine Dotierungsmaskenöffnung. Im Unterschied zu der Metallmaske 20 gemäss Figur 1a-c wird bei dieser Ausführungsform eine n-Dotierung als Maske 200 verwendet. Selbstverständlich ist auch die Kombination einer n-Dotierung als Maske und einer zusätzlichen Maskenschicht auf der dotierten Substratoberfläche, z.B. Nitrid, möglich.

Fig. 3a,b zeigen eine weitere Variante der Ausführungsform des erfindungsgemässen Herstellungsverfahrens nach Fig. 1.

Bei der Variante gemäss Figur 3 sind die n-dotierten Bereiche 30 in verschiedenen Tiefen vorgesehen. Dies ist insbesondere durch Wahl verschiedener Implantationsenergien möglich. Dadurch können auch Strukturen mit sehr komplexen Tiefenprofilen hergestellt werden. Bei dem in Figur 3a,b dargestellten Beispiel sind zwei verschiedene Implantationen zur Erstellung der oberen Funktionsebene mit den n-dotierten Bereichen 15a und zur Herstellung der Funktionsebene mit den n-dotierten Bereichen 15b durchgeführt worden. Ansonsten verlaufen die Verfahrensschritte wie bereits mit Bezug auf Figur 1a-c ausführlich beschrieben.

Eine weitere Möglichkeit, die zweite Funktionsebene einzubringen, ist nach der Implantation der ersten Funktionsebene eine Epitaxieschicht aufzubringen, in die die zweite Funktionsebene implantiert wird.

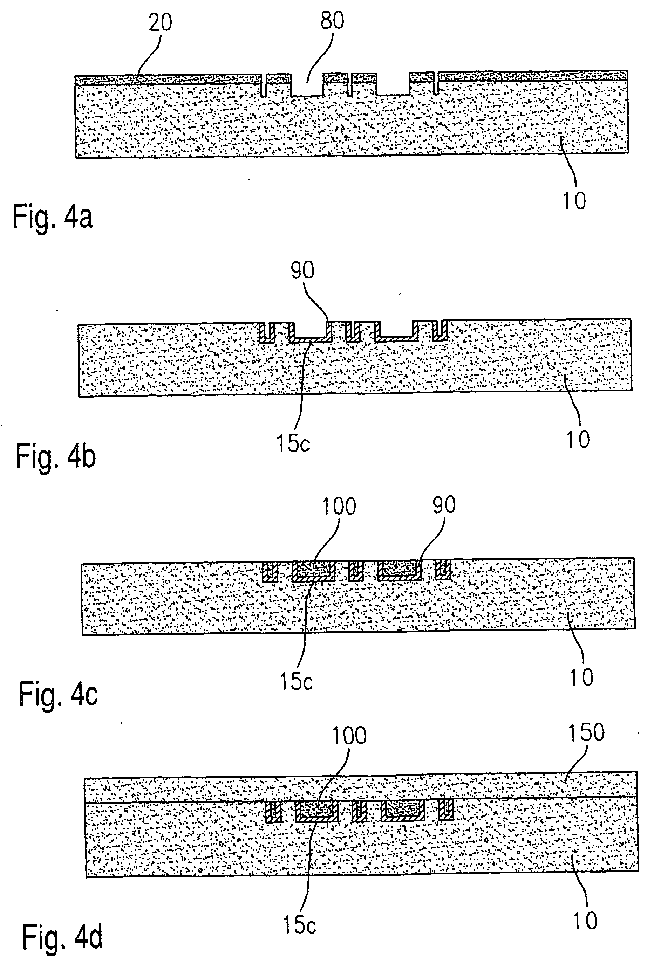

Fig. 4a-d zeigen noch eine weitere Variante der Ausführungsform des erfindungsgemässen Herstellungsverfahrens nach Fig. 1.

In Figur 4a bezeichnet 80 zusätzlich zu den bereits eingeführten Bezugszeichen Gräben im p-dotierten Halbleitersubstrat 10. Diese Gräben werden gemäss üblicher Techniken in das Halbleitersubstrat 10 eingebracht, beispielsweise durch eine Ätztechnik in Verbindung mit einer Hartmaske.

Wie in Figur 4b gezeigt, findet nach der Schaffung der Gräben 80 eine Gasphasenbelegung mit einer n-dotierten Belegungsschicht 90, z.B. Epitaxiesilizium, statt, um die n-dotierten Bereiche 15c zu bilden. Anschliessend werden, wie mit Bezug auf Figur 4c dargestellt, die Gräben mittels eines Füllmaterials, z.B. Polysilizium, aufgefüllt und die resultierende Struktur planarisiert. Schliesslich erfolgt mit Bezug auf Figur 4d die Abscheidung einer Epitaxie-Polysiliziumschicht 150.

Diese Vorgehensweise von Grabenbildung, Dotierung, Auffüllung und epitaktischer Abscheidung lässt sich zyklisch wiederholen, um komplizierte Tiefenprofile zu erzeugen. Insbesondere ermöglicht diese Variante zur Erzeugung der n-dotierten Bereiche mittels der Gräben 80 und der Belegungsschicht 90 die Erstellung eines sehr scharfen Dotierungsprofils mit hohem Aspektverhältnis. Zur Auffüllung kann neben z.B. n-dotierten Polysilizium auch Oxid, BPSG u.ä. verwendet werden. Insbesondere kann das Füllmaterial 100 auch entweder n-dotiert oder p-dotiert sein, je nachdem wie die resultierende Struktur aussehen soll.

Im Anschluss an Figur 4d finden die mit Bezug auf Figur 1b und c erläuterten weiteren Prozessschritte statt.

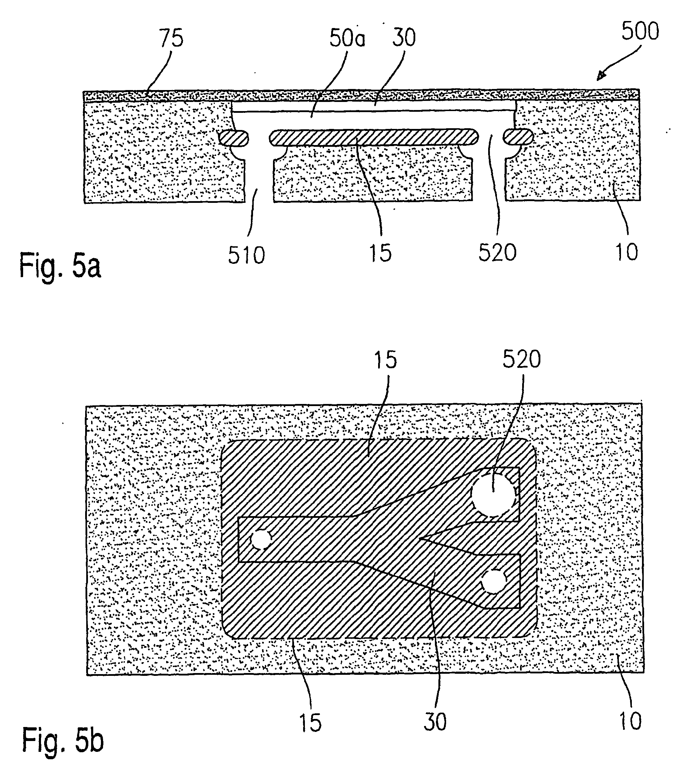

Fig. 5a,b zeigen eine schematische Darstellung eines mikromechanischen Bauelements gemäss einer ersten Ausführungsform der vorliegenden Erfindung, und zwar Fig. 5a in Querschnittsansicht und Fig. 5b in Draufsicht.

Figur 5a, b illustrieren eine Anwendung als verzweigten Strömungskanal mit definierten Durchlassöffnungen. Bei dieser Ausführungsform sind die Durchlassöffnungen als Rückseitenöffnungen 510 vorgesehen, während der poröse Bereich 30 durch eine Verschlussschicht 75 hermetisch verschlossen ist. Die n-dotierten Bereiche 15 dienen zur Begrenzung des Hohlraums 50a nach unten und damit als Boden des Strömungskanals. Die y-förmige Struktur des Strömungskanals lässt sich durch eine geeigende Maskierung erreichen.

Insbesondere sind bei der in Figur 5a, b gezeigten Struktur Durchlassöffnungen 520 vorgesehen, welche in dem n-dotierten Bereich 15 vorgesehen sind und dafür, dass beim Ätzen der Rückseitenöffnungen 510 von der Rückseite her, die Durchgänge nicht so gross werden, was durch das entsprechende kelchförmige Rückseitenätzprofil angedeutet ist. Insofern wirkt der n-dotierte Bereich 15 auch als Ätzstop für das Ätzen von der Rückseite her.

Bei einer nichtgezeigten Weiterbildung der Struktur nach Figur 5a, b wird eine zusätzliche Epitaxieschicht abgeschieden und darauf werden Leistungsbauelemente, z.B. Leistungstranistoren realisiert. Dann kann der Strömungskanal eine Kühlflüssigkeit oder ein Kühlgas bzw. ein anderes Kühlmedium leiten, so dass die Leistungsbauelemente von der Rückseite her mit guter thermischer Ankopplung gekühlt werden können. Dies hätte gegenüber einer Kühlung von der Vorderseite den Vorteil, dass die Oberfläche nicht vor dem Kühlmedium geschützt werden müsste. Bevorzugt wird für diese nicht gezeigte Anwendung der Strömungskanal mäanderförmig oder in sonstiger Richtung verschlungen ausgeführt.

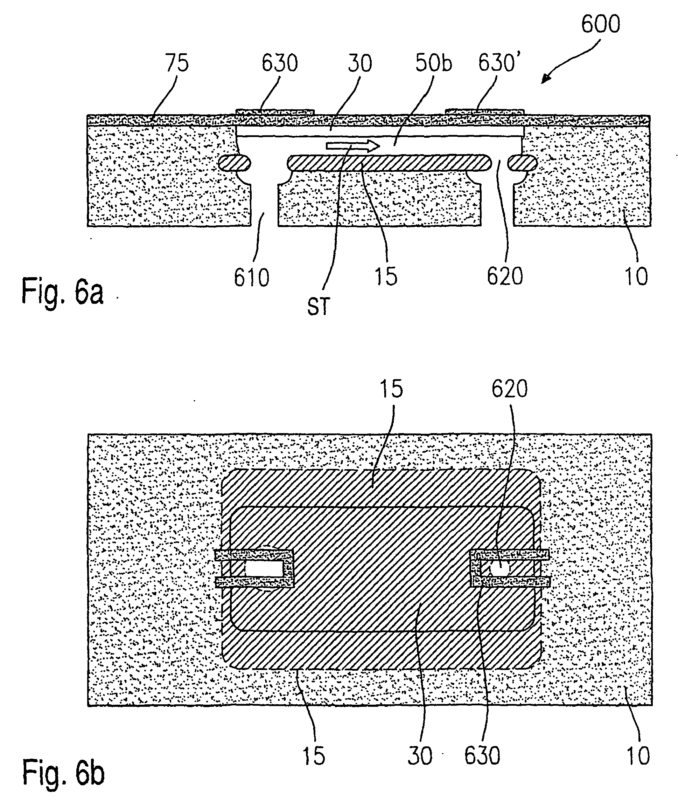

Fig. 6a,b zeigen eine schematische Darstellung eines mikromechanischen Bauelements gemäss einer zweiten Ausführungsform der vorliegenden Erfindung, und zwar Fig. 6a in Querschnittsansicht und Fig. 6b in Draufsicht.

Die in Figur 6a, b gezeigte Struktur ist eine Weiterbildung der in Figur 5a, b gezeigten Struktur. Hierbei sind piezoresistive Widerstandselemente 630, 630' auf der Verschlussschicht oberhalb des porösem Bereichs 30 vorgesehen. Bei unterschiedlichen Strömungsgeschwindigkeiten in Strömungsrichtung ST ergibt sich somit ein unterschiedlicher Druck, der die Membran und somit die piezoresistiven Widerstände 630, 630' unterschiedlich starker Spannung aussetzt. Die daraus resultierende Widerstandsänderung kann ausgewertet werden. Möglich ist auch der Einsatz einer Heizstruktur mit Temperaturfühlern analog bis zu bisherigen thermischen Massenflusssensoren.

Vorteilhaft ist hierbei, dass aufgrund der Zuführung des Massenflusses von der Rückseite her kein Medienschutz der Widerstandselemente 630, 630' notwendig ist.

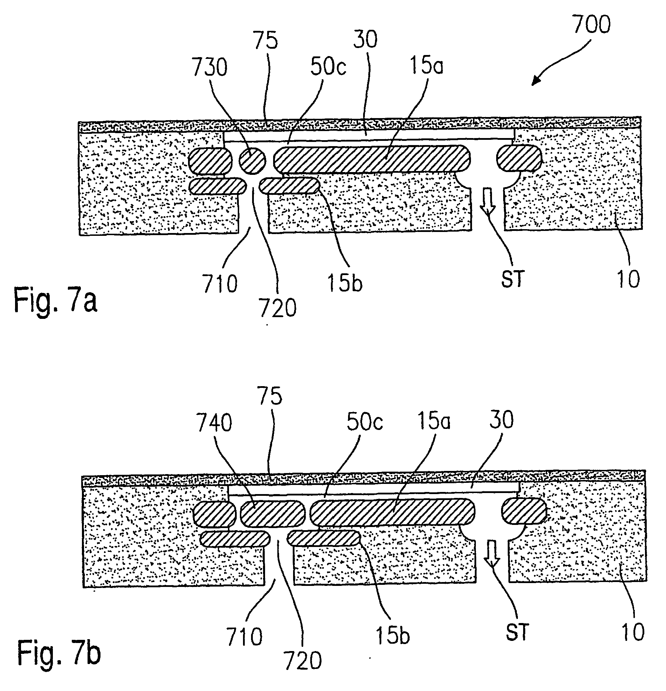

Fig. 7a,b zeigen eine schematische Querschnittsansicht eines mikromechanischen Bauelements gemäss einer dritten Ausführungsform der vorliegenden Erfindung, und zwar Fig. 7a mit einer Mikro-Verschlusskugel und Fig. 7b mit einer Mikro-Verschlussplatte.

Die in Figur 7a, b gezeigte Ausführungsform betrifft ein Rückschlagventil. Hier bezeichnet 730 eine Mikro-Verschlusskugel in Figur 7a und 740 ein Mikro-Verschlussplatte in Figur 7b, welche zusammen mit Durchgangsöffnung 720 in dem n-dotierten Bereich 15b ein Rückschlagventil bilden. Dabei werden die Mikro-Verschlusskugel 730 bzw. die Mikro-Verschlussplatte 740 während des Anodisierungsprozesses gleichzeitig mit dem Durchgangskanal bzw. der Durchlassöffnung 720 erzeugt und sorgen für eine Abdichtung der Durchlassöffnung 720 bei einem Rückfluss.

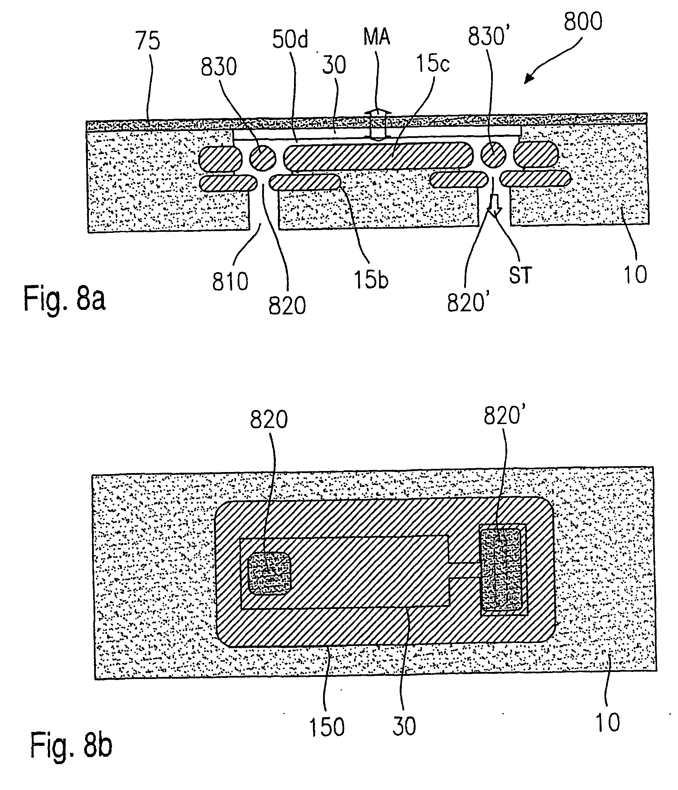

Fig. 8a,b zeigen eine schematische Darstellung eines mikromechanischen Bauelements gemäss einer vierten Ausführungsform der vorliegenden Erfindung, und zwar Fig. 8a in Querschnittsansicht und Fig. 8b in Draufsicht.

Bei dem in Figur 8a, b dargestellten Beispiel handelt es sich um eine Mikropumpe. Bei diesem Beispiel ist die Membran bestehend aus dem porösem Bereich 30 und der Verschlussschicht 75 dünner ausgebildet und in der Richtung MA auslenkbar.

Solch eine Auslenkung kann z.B. dadurch realisiert werden, dass eine magnetische Schicht als Verschlussschicht 75 verwendet wird, welche durch einen Elektromagneten auslenkbar ist. Ebenfalls denkbar sind eine thermische Auslenkung der Membran oder eine elektrostatische Auslenkung. Dabei vergrössert bzw. verkleinert sich der Hohlraum 50d volumenmässig, und durch den Einsatz zweier unterschiedlicher Rückschlagventile 830, 830' lässt sich eine Strömungsrichtung ST einprägen. Beim vorliegenden Beispiel ist das Rückschlagventil 830 kugelförmig ausgeführt und das Rückschlagventil 830' in Form eines Ellipsoid, welches mit einer ellipsenförmigen länglichen Öffnung zusammenwirkt.

Beim Auslenken der Membran nach oben verschliesst das Rückschlagventil 830' den rechten Einlass, während an dem Rückschlagventil Flüssigkeit vorbeiströmen kann. Somit wird durch die linke Durchlassöffnung Flüssigkeit angesaugt. Beim Auslenken nach unten verschliesst das linke Rückschlagventil 830 die runde Durchlassöffnung, während an dem rechten Durchschlagventil 830' Flüssigkeit vorbeiströmen kann. Somit wird die angesaugte Flüssigkeit durch die rechte Durchlassöffnung herausgedrückt.

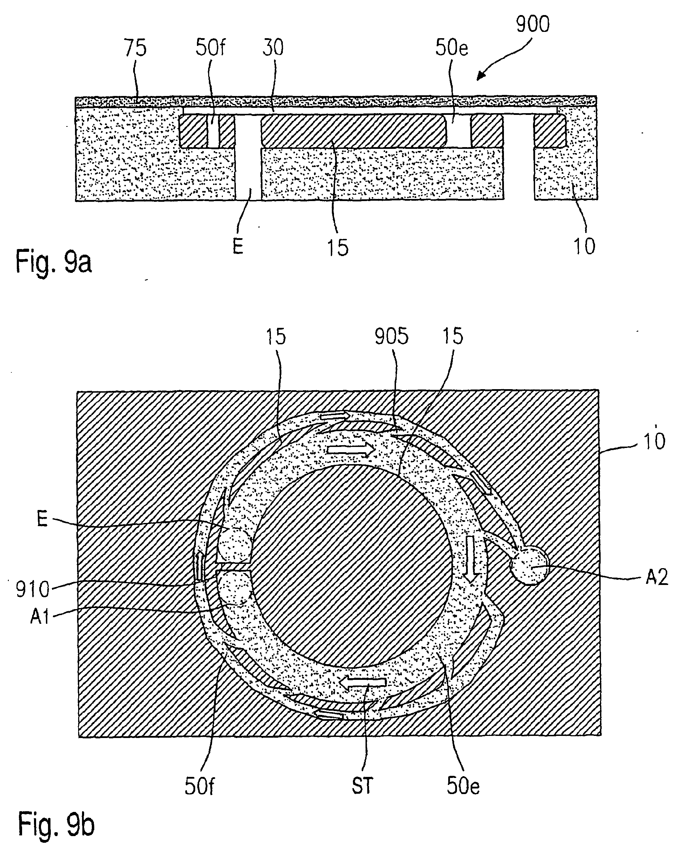

Fig. 9a,b zeigen eine schematische Darstellung eines mikromechanischen Bauelements gemäss einer fünften Ausführungsform der vorliegenden Erfindung, und zwar Fig. 9a in Querschnittsansicht und Fig. 9b in Draufsicht.

Die in Figur 9a, b gezeigte Struktur stellt eine Gaszentrifuge dar. Die Gaszentrifuge umfasst einen kreisförmigen inneren Strömungskanal 50e und einen konzentrischen äusseren Strömungskanal 50f, welche durch radiale Durchgangsöffnungen 905 in einem Trennbereich 15 aus dem Substratmaterial miteinander verbunden sind. Der innere Strömungskanal ist durch einen Steg 910 unterbrochen. Auf der einen Seite des Stegs befindet sich eine Rückseiten-Eingangsöffnung E, und auf der anderen Seite des Stegs 910 ist eine erste Rückseiten-Ausgangsöffnung A1 vorgesehen. Im äusseren Strömungskanal 50f ist eine zweite Rückseitenöffnung A2 am Ende vorgesehen. Damit ist ein durch die Rückseiten-Eingangsöffnung E einströmendes Medium durch die Zentrifugalkraft massenspezifisch zur ersten bzw. zweiten Rückseiten-Ausgangsöffnung A1, A2 leitbar. Mit anderen Worten werden aufgrund der Zentrifugalkraft die schwereren Gasbestandteile in den äusseren Strömungskanal 50f gedruckt, während die leichteren Gasbestandteile in den inneren Strömungskanal 50e bleiben. Zur Verstärkung der betreffenden Trennwirkung können mehrere solcher Gaszentrifugen seriell hintereinander geschaltet werden.

Obwohl die vorliegende Erfindung vorstehend anhand bevorzugter Ausführungsbeispiele beschrieben wurde, ist sie darauf nicht beschränkt, sondern auf vielfältige Weise modifizierbar.

Es können insbesondere beliebige mikromechanische Grundmaterialien, wie z.B. Germanium, verwendet werden, und nicht nur das exemplarisch angeführte Siliziumsubstrat. Auch können beliebige Sensorstrukturen gebildet werden.

## Patentansprüche

1. Mikromechanisches Bauelement mit:
einem Halbleitersubstrat (10) aus einem Substratmaterial mit einem ersten Dotierungstyp;
einer in dem Halbleitersubstrat (10) erstellten mikromechanischen Funktionsstruktur; und
einer Abdeckschicht (30) zum zumindest teilweisen Abdecken der mikromechanischen Funktionsstruktur;
**dadurch gekennzeichnet, dass**
die mikromechanische Funktionsstruktur Bereiche (15; 15a; 15b; 15c; 730; 740; 830) aus dem Substratmaterial mit einem zweiten entgegengesetzten Dotierungstyp aufweist, die zumindest teilweise von einem Hohlraum (50; 50a-f) umgeben sind; und
die Abdeckschicht (30) aus einer porösen Schicht (30) aus dem Substratmaterial besteht.

2. Mikromechanisches Bauelement nach Anspruch 1, **dadurch gekennzeichnet, dass** eine Verschlussschicht (75) zum Verschließen der Poren der porösen Schicht (30) erstellt ist, die im Hohlraum (50; 50a-f) eine vorbestimmte Atmosphäre einschließt.

3. Mikromechanisches Bauelement nach Anspruch 2, **dadurch gekennzeichnet, dass** die Verschlussschicht (75) eine auf der porösen Schicht (30) gebildete Oxidschicht aufweist.

4. Mikromechanisches Bauelement nach Anspruch 1, 2 oder 3, **dadurch gekennzeichnet, dass** über mindestens einem der Bereiche (15; 15a; 15b; 15c; 730; 740; 830) aus dem Substratmaterial mit dem zweiten entgegengesetzten Dotierungstyp ein Stützbereich (40) zum Stützen des porösen Bereichs (30) erstellt ist.

5. Mikromechanisches Bauelement nach einem der vorhergehenden Ansprüche, **dadurch gekennzeichnet, dass** mindestens einer der Bereiche (15; 15a; 15b; 15c; 730; 740; 830) aus dem Substratmaterial mit dem zweiten entgegengesetzten Dotierungstyp vollständig von seiner Umgebung losgelöst oder federnd mit dem Substrat verbunden ist.

6. Mikromechanisches Bauelement nach einem der vorhergehenden Ansprüche, **dadurch gekennzeichnet, dass** der Hohlraum (50a-f) einen Strömungskanal umfasst, der durch mindestens zwei Rückseitenöffnungen (E, A1, A2; 510; 610; 710; 810) anschließbar ist.

7. Mikromechanisches Bauelement nach Anspruch 6, **dadurch gekennzeichnet, dass** die Rückseitenöffnungen (E, A1, A2; 510; 610; 710; 810) über eine jeweilige Durchlassöffnung (520, 620, 720, 820, 820') angeschlossen sind, die im Bereich (15) gebildet ist.

8. Mikromechanisches Bauelement nach Anspruch 6 oder 7, **dadurch gekennzeichnet, dass** eine Verschlussschicht (75) zum Verschließen der Poren der porösen Schicht (30) erstellt ist und auf der Verschlussschicht (75) eine Erfassungseinrichtung (630; 630') zum piezoresistiven Erfassen der Strömungsgeschwindigkeit erstellt ist.

9. Mikromechanisches Bauelement nach Anspruch 7 oder 8, **dadurch gekennzeichnet, dass** innerhalb des Strömungskanals eine Rückschlagventileinrichtung oberhalb einer entsprechenden Durchlassöffnung (520, 620, 720, 820, 820') erstellt ist, die mindestens einen der Bereiche (730; 740; 830) aus dem Substratmaterial mit dem zweiten entgegengesetzten Dotierungstyp aufweist, der vollständig von seiner Umgebung losgelöst oder federnd mit dem Substrat verbunden ist.

10. Mikromechanisches Bauelement nach Anspruch 8, **dadurch gekennzeichnet, dass** zwei Rückschlagventileinrichtungen unterschiedlicher Geometrie oberhalb einer entsprechenden Durchlassöffnung (820, 820') erstellt sind; eine Verschlussschicht (75) zum Verschließen der Poren der porösen Schicht (30) erstellt ist; und der poröse Bereich (30) mit der Verschlussschicht (75) als Pumpenmembran derart auslenkbar ist, dass sich das Volumen des Hohlraums (50d) verändert.

11. Mikromechanisches Bauelement nach einem der vorhergehenden Ansprüche, **dadurch gekennzeichnet, dass** der Hohlraum (50a-f) einen kreisförmigen inneren Strömungskanal (50e) und einen konzentrischen äußeren Strömungskanal (50f) umfasst, welche durch radiale Durchgangsöffnungen (905) in einem Trennbereich (15) aus dem Substratmaterial mit dem zweiten entgegengesetzten Dotierungstyp verbunden sind, wobei der innere Strömungskanal (50e) durch einen Steg (910) unterbrochen ist und auf der einen Seite des Stegs (910) eine Rückseiten-Eingangsöffnung (E) und auf der anderen Seite des Stegs (910) eine erste Rückseiten-Ausgangsöffnung (A1) erstellt sind, und wobei im äußeren Strömungskanal (50f) eine zweite Rückseiten-Ausgangsöffnung (A2) erstellt ist; so dass ein durch die Rückseiten-Eingangsöffnung (E) einströmendes Medium durch die Zentrifugalkraft massenspezifisch durch die erste und zweite Rückseiten-Ausgangsöffnung (A1; A2) separierbar ist.

12. Mikromechanisches Bauelement nach einem der vorhergehenden Ansprüche, **dadurch gekennzeichnet, dass** das Substratmaterial Silizium ist.

13. Mikromechanisches Bauelement nach einem der vorhergehenden Ansprüche, **dadurch gekennzeichnet, dass** die Bereiche (15; 15a; 15b; 15c; 730; 740; 830) aus dem Substratmaterial mit dem zweiten entgegengesetzten Dotierungstyp in verschiedenen Tiefen im Substrat (10) erstellt sind.

14. Verfahren zur Herstellung eines mikromechanischen Bauelementes mit den Schritten:
Bereitstellen eines Halbleitersubstrats (10) aus einem Substratmaterial mit einem ersten Dotierungstyp;
Erstellen einer mikromechanischen Funktionsstruktur in das Halbleitersubstrat (10); und
Erstellen einer Abdeckschicht (30) zum zumindest teilweisen Abdecken der mikromechanischen Funktionsstruktur;
**gekennzeichnet durch** die Schritte
Erstellen von Bereichen (15; 15a; 15b; 15c; 730; 740; 830) aus dem Substratmaterial mit einem zweiten entgegengesetzten Dotierungstyp in der mikromechanischen Funktionsstruktur;
Bilden einer Maske (20; 200); und
anodisches Ätzen des Halbleitersubstrats (10) **durch** die Maske (20; 200) hindurch zur Herstellung der mikromechanischen Funktionsstruktur mit den Bereichen (15; 15a; 15b; 15c; 730; 740; 830), so dass die Bereiche (15; 15a; 15b; 15c; 730; 740; 830) zumindest teilweise von einem Hohlraum (50; 50a-f) umgeben sind und sich die Abdeckschicht (30) als eine poröse Schicht (30) aus dem Substratmaterial bildet.

15. Verfahren nach Anspruch 14, **dadurch gekennzeichnet, dass** eine Verschlussschicht (75) zum Verschließen der Poren der porösen Schicht (30) erstellt wird, die im Hohlraum (50; 50a-f) eine vorbestimmte Atmosphäre einschließt.

16. Verfahren nach Anspruch 14 oder 15, **dadurch gekennzeichnet, dass** die Verschlussschicht (75) durch eine Oxidation der porösen Schicht (30) gebildet wird.

17. Verfahren nach Anspruch 14, 15 oder 16, **dadurch gekennzeichnet, dass** eine Temperung durchgeführt wird, um einen oberflächlich gebildeten porösen Film auf den Bereichen (15; 15a; 15b; 15c; 730; 740; 830) zu entfernen.

18. Verfahren nach einem der Ansprüche 14 bis 17, **dadurch gekennzeichnet, dass** die Maske (200) durch Dotieren der Oberfläche des Substrats (10) zum Erzeugen von Maskenbereichen des zweiten entgegengesetzten Dotierungstyps gebildet wird.

19. Verfahren nach einem der Ansprüche 14 bis 18, **dadurch gekennzeichnet, dass** die Bereiche (15; 15a; 15b; 15c; 730; 740; 830) aus dem Substratmaterial mit dem zweiten entgegengesetzten Dotierungstyp in verschiedenen Tiefen ins Substrat (10) eingebracht werden.

20. Verfahren nach Anspruch 19, **dadurch gekennzeichnet, dass** die Bereiche (15; 15a; 15b; 15c; 730; 740; 830) durch eine zyklische Abfolge von Dotieren des Substrats (10) und epitaktischem Abscheiden des Substratmaterials hergestellt werden.

21. Verfahren nach Anspruch 19, **dadurch gekennzeichnet, dass** die Bereiche (15; 15a; 15b; 15c; 730; 740; 830) durch mehrere Implantationen mit verschiedenen Eindringtiefen hergestellt werden.

22. Verfahren nach einem der Ansprüche 14 bis 20, **dadurch gekennzeichnet, dass** die Bereiche (15; 15a; 15b; 15c; 730; 740; 830) aus dem Substratmaterial mit dem zweiten entgegengesetzten Dotierungstyp durch die folgenden Schritte hergestellt werden:
Erstellen von Gräben (80) in dem Halbleitersubstrat (10);
Belegen der Gräben (80) mit einer dotierten Halbleiterschicht (90) des zweiten entgegengesetzten Dotierungstyps;
Auffüllen der Gräben mit einem Füllmaterial (100);
Planarisieren der resultierenden Struktur; und
epitaktisches Abscheiden des Substratmaterials.

23. Verfahren nach Anspruch 22, **dadurch gekennzeichnet, dass** das Belegen der Gräben (80) mit einer dotierten Halbleiterschicht (90) des zweiten entgegengesetzten Dotierungstyps durch eine Gasphasenabscheidung erfolgt.

## Claims

1. Micromechanical component, having:
a semiconductor substrate (10) made from a substrate material with a first doping type;
a micromechanical functional structure produced in the semiconductor substrate (10); and
a covering layer (30) for at least partially covering the micromechanical functional structure;
**characterized in that**
the micromechanical functional structure includes regions (15; 15a; 15b; 15c; 730; 740; 830) of the substrate material with a second, opposite doping type, which are at least partially surrounded by a cavity (50; 50a-f); and
the covering layer (30) comprises a porous layer (30) of the substrate material.

2. Micromechanical component according to Claim 1, **characterized in that** a closure layer (75) for closing off the pores of the porous layer (30) is produced and encloses a predetermined atmosphere in the cavity (50; 50a-f).

3. Micromechanical component according to Claim 2, **characterized in that** the closure layer (75) has an oxide layer formed on the porous layer (30).

4. Micromechanical component according to Claim 1, 2 or 3, **characterized in that** a supporting region (40) for supporting the porous region (30) is produced above at least one of the regions (15; 15a; 15b; 15c; 730; 740; 830) of the substrate material with the second, opposite doping type.

5. Micromechanical component according to one of the preceding claims, **characterized in that** at least one of the regions (15; 15a; 15b; 15c; 730; 740; 830) of the substrate material with the second, opposite doping type is completely detached from its surroundings or is resiliently joined to the substrate.

6. Micromechanical component according to one of the preceding claims, **characterized in that** the cavity (50a-f) comprises a flow channel which can be connected through at least two back-surface openings (E, A1, A2; 510; 610; 710; 810).

7. Micromechanical component according to Claim 6, **characterized in that** the back-surface openings (E, A1, A2; 510; 610; 710; 810) are connected via a respective passage opening (520, 620, 720, 820, 820') which has been formed in the region (15).

8. Micromechanical component according to Claim 6 or 7, **characterized in that** a closure layer (75) is produced for closing off the pores of the porous layer (30), and a recording device (630; 630') for piezo-resistively recording the flow velocity is produced on the closure layer (75).

9. Micromechanical component according to Claim 7 or 8, **characterized in that** a nonreturn valve device is produced within the flow channel above a corresponding passage opening (520, 620, 720, 820, 820'), which includes at least one of the regions (730; 740; 830) of the substrate material with the second, opposite doping type which is completely separate from its surroundings or is resiliently joined to the substrate.

10. Micromechanical component according to Claim 8, **characterized in that** two nonreturn valve devices of different geometry are produced above a corresponding passage opening (820, 820'); a closure layer (75) is produced for closing off the pores of the porous layer (30); and the porous region (30) with the closure layer (75) can be deflected as a pump diaphragm in such a manner that the volume of the cavity (50d) changes.

11. Micromechanical component according to one of the preceding claims, **characterized in that** the cavity (50a-f) comprises a circular inner flow channel (50e) and a concentric outer flow channel (50f), which are connected by radial aperture openings (905) in a separating region (15) of the substrate material with the second, opposite doping type, the inner flow channel (50e) being interrupted by a web (910), and a back-surface entry opening (E) being produced on one side of the web (910) and a first back-surface exit opening (A1) being produced on the other side of the web (910), and a second back-surface exit opening (A2) being produced in the outer flow channel (50f); so that a medium which flows in through the back-surface entry opening (E) can be separated in mass-specific fashion by the centrifugal force so as to pass through the first and second back-surface exit openings (A1; A2).

12. Micromechanical component according to one of the preceding claims, **characterized in that** the substrate material is silicon.

13. Micromechanical component according to one of the preceding claims, **characterized in that** the regions (15; 15a; 15b; 15c; 730; 740; 830) of the substrate material with the second, opposite doping type are produced at different depths in the substrate (10).

14. Process for producing a micromechanical component, comprising the steps of:
providing a semiconductor substrate (10) of a substrate material with a first doping type;
producing a micromechanical functional structure in the semiconductor substrate (10); and
producing a covering layer (30) for at least partially covering the micromechanical functional structure;
**characterized by** the steps of
producing regions (15; 15a; 15b; 15c; 730; 740; 830) of the substrate material with a second, opposite doping type in the micromechanical functional structure;
forming a mask (20; 200); and
anodically etching the semiconductor substrate (10) through the mask (20; 200) to produce the micromechanical functional structure having the regions (15; 15a; 15b; 15c; 730; 740; 830), so that the regions (15; 15a; 15b; 15c; 730; 740; 830) are at least partially surrounded by a cavity (50; 50a-f) and the covering layer (30) is formed as a porous layer (30) of the substrate material.

15. Process according to Claim 14, **characterized in that** a closure layer (75) is produced for closing off the pores of the porous layer (30), which closure layer encloses a predetermined atmosphere in the cavity (50; 50a-f).

16. Process according to Claim 14 or 15, **characterized in that** the closure layer (75) is formed by oxidation of the porous layer (30).

17. Process according to Claim 14, 15 or 16, **characterized in that** a conditioning treatment is carried out in order to remove a porous film that is formed on the surface on the regions (15; 15a; 15b; 15c; 730; 740; 830).

18. Process according to one of Claims 14 to 17, **characterized in that** the mask (200) is formed by doping the surface of the substrate (10) to produce mask regions of the second, opposite doping type.

19. Process according to one of Claims 14 to 18, **characterized in that** the regions (15; 15a; 15b; 15c; 730; 740; 830) of the substrate material with the second, opposite doping type are introduced different depths into the substrate (10).

20. Process according to Claim 19, **characterized in that** the regions (15; 15a; 15b; 15c; 730; 740; 830) are produced by a cyclical sequence of doping the substrate (10) and epitaxially depositing the substrate material.

21. Process according to Claim 19, **characterized in that** the regions (15; 15a; 15b; 15c; 730; 740; 830) are produced by a plurality of implantation operations with different penetration depths.

22. Process according to one of Claims 14 to 20, **characterized in that** the regions (15; 15a; 15b; 15c; 730; 740; 830) of the substrate material with the second, opposite doping type are produced by the following steps:
producing trenches (80) in the semiconductor substrate (10);
lining the trenches (80) with a doped semiconductor layer (90) of the second, opposite doping type;
filling the trenches with a filling material (100);
planarizing the resulting structure; and
epitaxially depositing the substrate material.

23. Process according to Claim 22, **characterized in that** the lining of the trenches (80) with a doped semiconductor layer (90) of the second, opposite doping type is effected by vapour deposition.

## Revendications

1. Composant micromécanique comprenant :
un substrat semi-conducteur (10) d'un matériau de substrat avec un premier type de dopage ;
une structure fonctionnelle micromécanique réalisée dans le substrat semi-conducteur (10) ; et
une couche de couverture (30) pour recouvrir au moins partiellement la structure fonctionnelle micromécanique ;
**caractérisé en ce que**
la structure fonctionnelle micromécanique présente des zones (15 ; 15a ; 15b ; 15c ; 730 ; 740 ; 830) en matériau de substrat avec un deuxième type de dopage opposé, qui sont au moins partiellement entourées par un espace creux (50 ; 50a-f) ; et
la couche de couverture (30) est une couche poreuse (30) en matériau de substrat.

2. Composant micromécanique selon la revendication 1,
**caractérisé en ce qu'**
une couche de fermeture (75) est réalisée pour fermer les pores de la couche poreuse (30), qui enferme une atmosphère prédéterminée dans l'espace creux (50 ; 50a-f).

3. Composant micromécanique selon la revendication 2,
**caractérisé en ce que**
la couche de fermeture (75) présente une couche d'oxyde formée sur la couche poreuse (30).

4. Composant micromécanique selon la revendication 1, 2 ou 3,
**caractérisé en ce qu'**
au-dessus d'au moins une des zones (15 ; 15a ; 15b ; 15c ; 730 ; 740 ; 830) en matériau de substrat avec le deuxième type de dopage opposé une zone de soutien (40) est réalisée pour soutenir la couche poreuse (30).

5. Composant micromécanique selon l'une quelconque des revendications précédentes,
**caractérisé en ce qu'**
au moins une des zones (15 ; 15a ; 15b ; 15c ; 730 ; 740 ; 830) en matériau de substrat avec le deuxième type de dopage opposé est complètement détachée de son environnement ou reliée de manière élastique au substrat.

6. Composant micromécanique selon l'une quelconque des revendications précédentes,
**caractérisé en ce que**
l'espace creux (50a-f) comprend un canal d'écoulement qui peut être raccordé par au moins deux ouvertures de face arrière (E, A1, A2 ; 510 ; 610; 710; 810).

7. Composant micromécanique selon la revendication 6,
**caractérisé en ce que**
les ouvertures de face arrière (E, A1, A2 ; 510 ; 610 ; 710 ; 810) sont raccordées par respectivement une ouverture de passage (520, 620, 720, 820, 820') située dans la zone (15).

8. Composant micromécanique selon la revendication 6 ou 7,
**caractérisé en ce qu'**
une couche de fermeture (75) est réalisée pour fermer les pores de la couche poreuse (30), et un dispositif de détection (630 ; 630') est réalisé sur la couche de fermeture (75) pour détecter de manière piézo-résistive la vitesse d'écoulement.

9. Composant micromécanique selon la revendication 7 ou 8,
**caractérisé en ce qu'**
un dispositif à clapet anti-retour est prévu à l'intérieur du canal d'écoulement au-dessus d'une ouverture de passage (520, 620, 720, 820, 820') correspondante qui présente au moins une des zones (730 ; 740 ; 830) en matériau de substrat avec le deuxième type de dopage opposé, qui est complètement détachée de son environnement ou reliée de manière élastique au substrat.

10. Composant micromécanique selon la revendication 8,
**caractérisé en ce que**
deux dispositifs à clapet anti-retour d'une géométrie différente sont prévus au-dessus d'une ouverture de passage (820, 820') correspondant ; une couche de fermeture (75) est prévue pour fermer les pores de la couche poreuse (30) ; et la couche poreuse (30) avec la couche de fermeture (75) en tant que membrane de pompe peut être déplacée pour faire varier le volume de l'espace creux (50d).

11. Composant micromécanique selon l'une quelconque des revendications précédentes,
**caractérisé en ce que**
l'espace creux (50a-f) comprend un canal d'écoulement (50e) circulaire intérieur et un canal d'écoulement (50f) concentrique extérieur, qui sont reliés par des ouvertures de passage radiales (905) situées dans une zone de séparation (15) en matériau de substrat avec le deuxième type de dopage opposé, le canal d'écoulement intérieur (50e) est interrompu par une nervure (910), une ouverture d'entrée de face arrière (E) est prévue d'un côté de la nervure (910), une première ouverture de sortie de face arrière (A1) de l'autre côté de la nervure (910), et une deuxième ouverture de sortie de face arrière (A2) est prévue dans le canal d'écoulement extérieur (50f) de telle sorte qu'un fluide entrant par l'ouverture d'entrée de face arrière (E) peut être séparé de manière spécifique de la masse par la force centrifuge par les première et deuxième ouvertures de sortie de face arrière (A1 ; A2).

12. Composant micromécanique selon l'une quelconque des revendications précédentes,
**caractérisé en ce que**
le matériau de substrat est du silicium.

13. Composant micromécanique selon l'une quelconque des revendications précédentes,
**caractérisé en ce que**
les zones (15 ; 15a ; 15b ; 15c ; 730 ; 740 ; 830) en matériau de substrat avec le deuxième type de dopage opposé sont réalisées à différentes profondeurs dans le substrat (10).

14. Procédé de fabrication d'un composant micromécanique avec les étapes :
- mise à disposition d'un substrat semi-conducteur (10) d'un matériau de substrat avec un premier type de dopage ;
- réalisation d'une structure fonctionnelle micromécanique dans le substrat semi-conducteur (10) ; et
- réalisation d'une couche de couverture (30) pour recouvrir au moins partiellement la structure fonctionnelle micromécanique ;
**caractérisé par**
les étapes suivantes :
- réalisation de zones (15 ; 15a ; 15b ; 15c ; 730 ; 740 ; 830) en matériau de substrat avec le deuxième type de dopage opposé dans la structure fonctionnelle micromécanique ;
- formation d'un masque (20 ; 200) ; et
- gravure anodique du substrat semi-conducteur (10) à travers le masque (20 ; 200) pour obtenir la structure fonctionnelle micromécanique avec les zones (15 ; 15a ; 15b ; 15c ; 730 ; 740 ; 830) de telle sorte que les zones (15 ; 15a ; 15b ; 15c ; 730 ; 740 ; 830) sont entourées au moins partiellement par un espace creux (50 ; 50a-f), et la couche de couverture (30) se forme comme une couche poreuse (30) en matériau de substrat.

15. Procédé selon la revendication 14,
**caractérisé en ce qu'**
on réalise une couche de fermeture (75) pour fermer les pores de la couche poreuse (30) qui enferme une atmosphère prédéterminée dans l'espace creux (50 ; 50a-f).

16. Procédé selon la revendication 14 ou 15,
**caractérisé en ce que**
on forme la couche de fermeture (75) par une oxydation de la couche poreuse (30).

17. Procédé selon la revendication 14, 15 ou 16,
**caractérisé en ce qu'**
on réalise une malléabilisation pour supprimer un film poreux formé à la surface des zones (15 ; 15a ; 15b ; 15c ; 730 ; 740 ; 830).

18. Procédé selon l'une quelconque des revendications 14 à 17,
**caractérisé en ce que**
on forme le masque (200) par dopage de la surface du substrat (10) pour obtenir des zones de masque du deuxième type de dopage opposé.

19. Procédé selon l'une quelconque des revendications 14 à 18,
**caractérisé en ce que**
on réalise les zones (15 ; 15a ; 15b ; 15c ; 730 ; 740 ; 830) en matériau de substrat avec le deuxième type de dopage opposé à différentes profondeurs dans le substrat (10).

20. Procédé selon la revendication 19,
**caractérisé en ce que**
on réalise les zones (15 ; 15a ; 15b ; 15c ; 730 ; 740 ; 830) par une séquence cyclique de dopage du substrat (10) et de dépôt épitaxial du matériau de substrat.

21. Procédé selon la revendication 19,
**caractérisé en ce que**
on réalise les zones (15 ; 15a ; 15b ; 15c ; 730 ; 740 ; 830) par plusieurs implantations avec des profondeurs de pénétration différentes.

22. Procédé selon l'une quelconque des revendications 14 à 20,
**caractérisé en ce que**
on réalise les zones (15 ; 15a ; 15b ; 15c ; 730 ; 740 ; 830) en matériau de substrat avec le deuxième type de dopage opposé par les étapes suivantes :
- réalisation de fosses (80) dans le substrat semi-conducteur (10) ;
- garniture des fosses (80) avec une couche semi-conductrice dopée (90) du deuxième type de dopage opposé ;
- remplissage des fosses avec un matériau de remplissage (100) ;
- égalisation de la structure résultante ; et
- dépôt épitaxial du matériau de substrat.

23. Procédé selon la revendication 22,
**caractérisé en ce que**
on effectue la garniture des fosses (80) avec une couche semi-conductrice (90) dopée du deuxième type de dopage opposé par dépôt en phase gazeuse.
